# EUROPEAN PATENT APPLICATION

(11) **EP 1 720 239 A1**
(43) Date of publication of application: **08.11.2006**
(21) Application number: 05009960.5
(22) Date of filing: 06.05.2005
(51) Int. Cl.: H02M 3/156, H03K 17/08

(54) **Dc/dc converter**

(71) Applicant: TTE Germany GmbH, 78048 Villingen-Schwenningen (DE)
(72) Inventor: Lopez, Daniel, 78052 VS-Obereschach (DE); Vogel, Stefan, 78086 Brigachtal (DE)
(74) Representative: Arnold, Klaus-Peter

(57) **Abstract**

A DC/DC converter comprises a switch-mode power supply with a switching transistor (M1), in particular a MOSFET transistor, which is coupled between a DC voltage supply (V3) and a load (V3), and a controlling circuit with a controller (4), which delivers driving pulses for the switching transistor (M1), and a transformer (TX1) between the controller (4) and the switching transistor (M1). The controlling circuit further comprises a primary circuit with a capacitor (C1) and a clamping circuit with a capacitor (C2). A main feature of the invention is that the controlling circuit further comprises a timing circuit, which switches the switching transistor (M1) off after a certain on-time of the controller (4).

## Description

### BACKGROUND OF THE INVENTION

### FIELD OF THE INVENTION

The present invention is related to a DC/DC converter, in particular a down-converter, according to the preamble of claim 1. A down-converter, also known as a buck converter or a step-down converter, converts a highDC-voltage to a lower stabilised DC-voltage.

### DESCRIPTION OF THE PRIOR ART

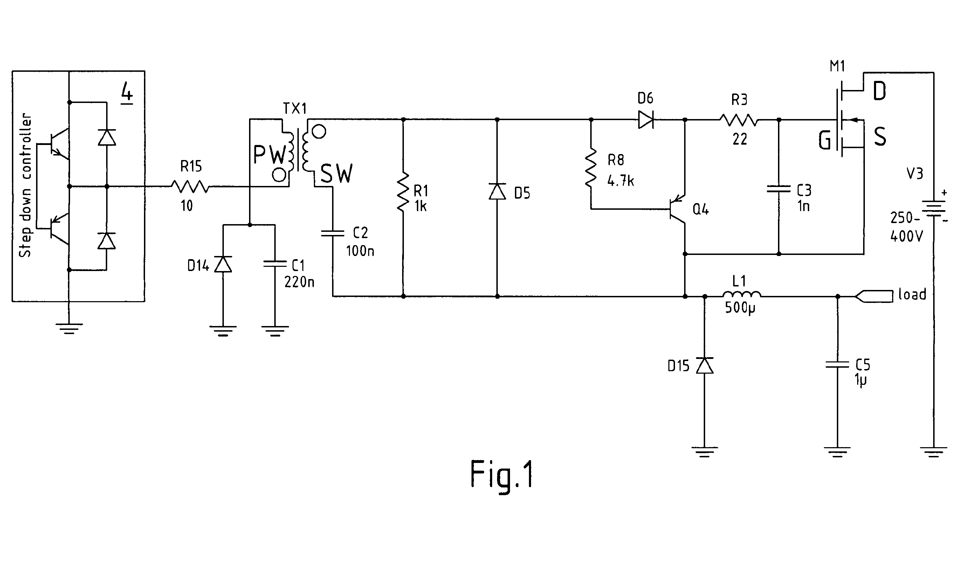

A DC/DC converter is described in the DE-Z "Schaltnetzteile in der Praxis", 1992, Würzburg, Germany, on pages 66, 67 and 72, 73. An improvement of this DC/DC converter, mentioned on page 73, is published in the DE-OS 37 30 503. These DC/DC converters differ in only a few points from a DC/DC converter of a prior art DC/DC converter known by the applicant and shown in figure 1.

Such a DC/DC converter comprises a switch-mode power supply with a N-channel MOSFET transistor as a switching transistor M1. The switching transistor M1 is coupled between a DC voltage supply V3 and a load. A N-channel MOSFET transistor offers, for certain voltages and for certain current capabilities, an acceptable low value of the resistance between its drain D and its source S at attractive costs.

A DC/DC converter further comprises a controlling circuit with a controller 4, which provides driving pulses with a specific duty cycle for the switching transistor M1, and a transformer TX1 between the controller 4 and the switching transistor M1. The transformer TX1 is required in order to transfer a pulse from a conventional controller with a range of 0 to 12 V and a duty cycle of a few % to 80% to the gate G and source S of the transistor M1, which are floating at a high voltage, for example about 100 Volts. The controlling circuit is also provided with a primary circuit with a capacitor C1 and with a clamping circuit with a capacitor C2. The primary circuit is required to avoid a core magnetisation in the transformer TX1. The clamping circuit makes it possible to achieve driving pulses with a shape similar to that of the pulses of the controller. As a result, a transformer TX1 with a ratio of 1 to 1 can be used.

A disadvantage of this DC/DC converter is apparent when the pulses of the controller are stopped by switch-off or by regulation, i.e. a controller output drops to zero over a longer period of time or the length of a positive controller pulse develops over a time longer than a switching cycle. Such conditions can cause currents, which discharge the capacitors C1 and C2. The resulting DC voltage conditions then cause a gate G of the switching transistor M1 to become positive for an undefinite time. This undefinite time can be long enough to destroy the MOSFET transistor M1 by a saturation current of a step-down coil L1 of the switch-mode power supply.

### SUMMARY OF THE INVENTION

It is therefore desirable to develop a DC/DC converter according to the preamble of claim 1 which provides a safe operation of the switching transistor, in particular for a MOSFET switching transistor.

According to the invention this can be achieved with a DC/DC converter as described by the features of the claim 1, namely by adding a timing circuit to the controlling circuit, which switches the switching transistor M1 off after a certain on-time of the controller.

Advantageous developments of the invention are specified in the dependent claims.

Under normal circumstances the controller delivers pulses with a specific duty cycle, i.e. with a specific pulse length during a pulse interval, as the DC voltage at the output of the controller quickly increases, stays high for the pulse length, quickly drops to zero and starts again at the end of the pulse intervals. As a result, the switching transistor is switched on due to a high voltage, transmitted from the controller through the transformer, and switched off due to a transmitted low voltage. The transmittance of the DC-pulses is supported by the primary circuit and by the clamping circuit. If the positive pulse of the controller is longer than a pulse interval or when the controller output slowly drops to zero, i.e. when the on-time of the controller is longer than usual, the switching transistor M1 is switched off reliably after the on-time by the timing circuit. The switching transistor M1 is protected from being destroyed.

Preferably the chosen on-time of the timing circuit corresponds to a value between one and two duty cycles of the controller. The on-time is e.g. 1,5 times the duty cycle.

In order to generate a time corresponding to the chosen on-time, the timing circuit comprises in particular timing elements with a time constant corresponding to the on-time.

The timing elements can comprise a resistor and a capacitor, with timing constant τ, which is a product of its resistance R and its capacity C: τ = R C.

The timing circuit can further comprise voltage storage means, which charge the timing elements. As a result, the charging of the timing elements and the switching off of the switching transistor are secured.

The voltage storage means can comprise a capacitor and a diode decoupling the capacitor from the clamping circuit.

The timing circuit may further comprise a transistor, which is controlled by the timing elements and in turn controls the switching transistor. The switching transistor is switched off by the transistor after the chosen on-time.

### BRIEF DESCRIPTION OF THE DRAWINGS

It shows:
figure 1 a simplified circuit diagram of a prior art DC/DC converter;
figure 2 a circuit diagram of a DC/DC converter of a first embodiment of the invention; and
figure 3 a circuit diagram of a DC/DC converter of a second embodiment of the invention.

### DETAILED DESCRIPTION OF A PRIOR ART DC/DC CONVERTER ()

As shown in figure 1, a prior art DC/DC down-converter known by the applicant is arranged as a switch-mode power supply with a N-channel MOSFET transistor as a switching transistor M1, which is coupled between a DC voltage supply V3 and a load 3. The value of the supplied DC voltage can vary between 250 V and 400 V. The generated voltage, which is used by the load 3, has i. e. a value of 200 V. The DC/DC converter further comprises a controlling circuit with an integrated controller 4, delivering driving pulses of a certain pulse length during a pulse interval for the switching transistor M1, and with a transformer TX1 between the controller 4 and the switching transistor M1. The transformer winding ratio can be from 1:1 to 1:2.

The controlling circuit comprises a primary circuit with a capacitor C1. The primary circuit is coupled to the controller 4 and a primary winding PW of the transformer TX1. The capacitor C1 is coupled in series with the primary winding PW. In addition to the capacitor C1 the primary circuit comprises a diode D14 and a resistor R15. The diode D14 is coupled in series with the primary winding PW and in parallel with the capacitor C1 and provides a limitation of negative voltages which could appear across capacitor C1 after switch-off. The resistor R15 is coupled in series with the primary winding PW and limits the current.

The controlling circuit is further provided with a clamping circuit with a capacitor C2, which is coupled in series with a secondary winding SW of the transformer TX1. The clamping circuit further comprises a resistor R1 and a diode D5, each of which is coupled in parallel with the secondary winding SW and the capacitor C2, and in parallel with one another.

The controlling circuit is also provided with a switch-off circuit equipped with a pnp-transistor as a switch-off transistor Q4, which controls a gate G of the switching transistor M1. In addition to the switch-off transistor Q4 the switch-off circuit comprises a diode D6 leading a positive current to the gate G of the switching transistor M1, and a resistor R8 which is coupled between a base and an emitter of the switch-off transistor Q4, , and whichlimits the base current of transistor Q4.

The controlling circuit further comprises a capacitor C3 and a resistor R3. The capacitor C3 is coupled between the gate G and the source S of the switching transistor M1. Such a capacitor is described in the above mentioned DE-OS 37 30 503. The resistor R3 is coupled between the emitter of the switch-off transistor Q4 and the gate G of the switching transistor M1.

The switch-mode power supply is further provided with a coil L1 connected with the load 3, a diode D15 and a capacitor C5. The diode D15 and the capacitor C5 are coupled both to ground with one end, and with the other ends to the coil L1 being in between. The diode D15 is coupled in a positive current direction in front of the coil L1, and the capacitor C5 is coupled behind the coil L1. The diode D15 acts as a self induction recuperation or free-wheeling diode.

A voltage sensor circuit, not shown in the figure 1, for sensing the voltage at the capacitor C5 is connected with the controller 4. The sensor circuit provides a feedback signal for a load-dependent regulation of the generated DC-voltage across the capacitor C5. The controller 4 is for example a known switched-mode power supply controller UC3843. A controller of this kind produces usually a pulse-width modulated voltage for driving a switching transistor, which voltage consists of periodic cycles of "high" and "low" voltage signals for switching the switching transistor on and off.

A positive pulse of the controller 4 is transmitted via the transformer TX1 thus generating a positive voltage at the gate G of the switching transistor M1. The switching transistor M1 is then switched on. A positive current in the clamping circuit and in the switch-off circuit charges the capacitors C2 and C3. The diode D6 is conductive while the diode D5 is non-conductive. Since its base and its emitter have a small reverse voltage potential, the switch-off transistor Q4 remains switched off.

At the end of the pulse the clamping circuit becomes active and generates a negative current. The diode D5 becomes conductive and begins to discharge the capacitor C2. The diode D6 is then switched off. As a result the potential of the base of the switch-off transistor Q4, in comparison to the potential of its emitter is lowered and the switch-off transistor Q4 is switched on. By switching on the switch-off transistor Q4, the switch-off circuit begins to discharge the capacitor C3 and internal gate capacitances of the switching transistor M1, and the potential at the gate is lowered so much that the switching transistor M1 is switched off.. These off-conditions remain until the controller 4 creates a new positive pulse, which is transmitted by the transformer TX1.

By controlling the gate G of the switching transistor M1 the pulses coming from the controller 4 create an increasing current in the coil L1. At switch off of the switching transistor M1 this current continues to flow, via diode D15, to charge the capacitor C5 further. The capacitance of the capacitor C5 is selected such that a smoothed DC-voltage is established across capacitor C5. At the capacitor C5 the generated DC-voltage is measured by the unshown sensor and used for regulation, as described above.

### DETAILED DESCRIPTION OF A FIRST EMBODIMENT OF THE INVENTION

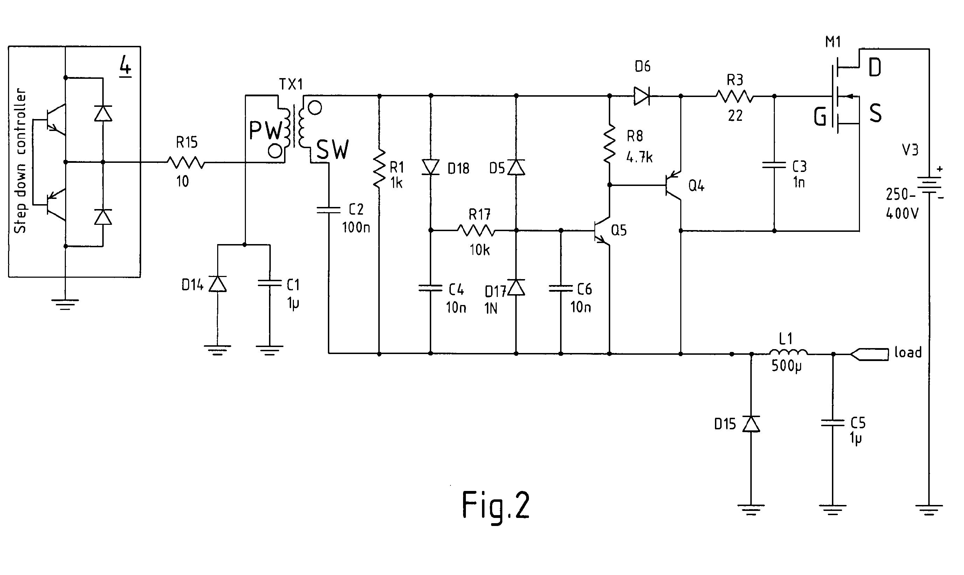

A DC/DC converter of a first embodiment, shown in figure 2,corresponds to a prior art DC/DC converter in all ways, except for the following features: The controlling circuit further comprises a timing circuit switching the switching transistor M1 off after a certain on-time of the controller 4.

The timing circuit comprises a resistor R17 and a capacitor C6 as timing elements, a capacitor C4 and a diode D18 as voltage storage means, a transistor Q5 and a diode D17.

The transistor Q5 is a npn-transistor and is coupled, with its collector, to the base of the switch-off transistor Q4, in order to control this transistor Q4. The transistor Q5 itself is controlled by the timing elements. The two timing elements, the resistor R17 and the capacitor C6, are coupled in series with one another and are connected with the base of the transistor Q5.

The diode D18 and the capacitor C4 of the voltage storage means are coupled in series with one another and are coupled in parallel with the resistor R1. The capacitor C4 is coupled via the resistor R17 to the capacitor C6. The capacitor C6 is directly connected with the diode D17, which closes the clamping circuit by being coupled in series with the diode D5. Both diodes D17 and D5 are coupled in the direction of a negative current. By being coupled in the direction of a positive current the diode D18 decouples the capacitor C4 from the clamping circuit.

A positive pulse from the controller 4 generates a positive current, which quickly charges the capacitor C4 through the diode D18. The capacitor C4 then charges the capacitor C6 through the resistor R17. Before the voltage at the capacitor C6 and the corresponding current at the base of the transistor Q5 are high enough to switch the transistor Q5 on, the clamping circuit is activated by the negative voltage now present at across the secondary winding SW of the transformer TX1. The capacitor C6 is then quickly discharged by the diode D5 and its voltage is clamped at - 0,7 V by the forward voltage of diode D17.

The voltage across capacitor C4 provides a current source for charging the capacitor C6 via the resistor R17. Only when the positive pulse does not end in due time or when the pulse has no definite end, after a time defined by charging the capacitor C6 from -0,7 V to 0,55 V, the transistor Q5 switches on. Subsequently, the transistor Q4 also switches on and as a result, switches the switching transistor M1 off.

The time constant τ of the timing elements thereby determines the on-time, after which the switching transistor M1 is switched off, in the above mentioned failure cases. The resistor R17 and the capacitor C6 and thereby the time constant τ are chosen in a way that the maximum on-time has a value between one and two switching cycles of the controller 4. In this example the value is 1,5 times the switching cycle.

### DETAILED DESCRIPTION OF A SECOND EMBODIMENT OF THE INVENTION

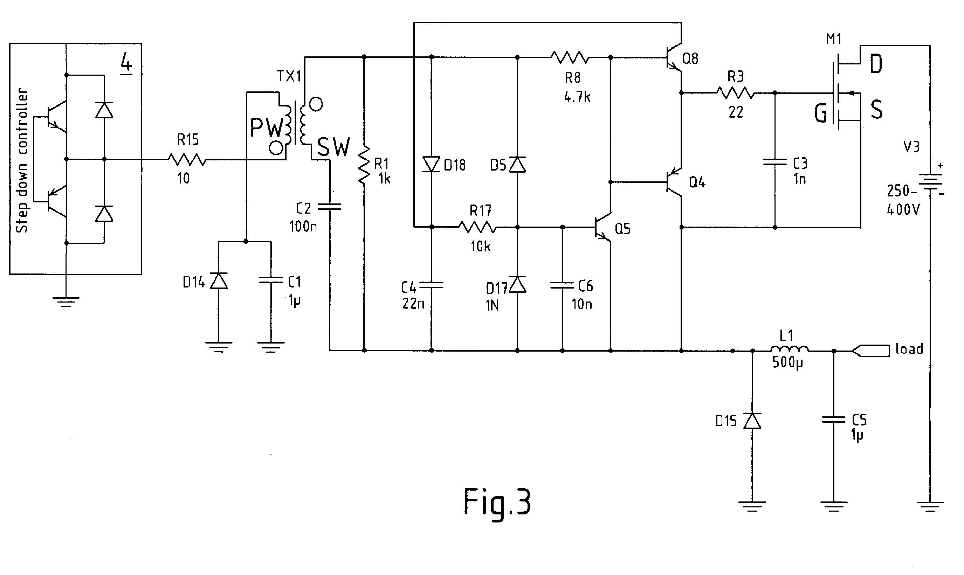

A DC/DC converter of a second embodiment, shown in figure 3, corresponds to the DC/DC converter of the first embodiment of the invention in all ways, except for the following features: The diode D6 is replaced. A npn-transistor as a switch-on transistor Q8 is coupled in a push-pull configuration with the switch-off transistor Q4. The collector of the switch-on transistor Q8 is connected with the decoupled capacitor C4 and its emitter is connected with the emitter of the transistor Q4. The resistor R8 is coupled so that it protects the two bases of the transistors Q4 and Q8. The capacitor C4 of the voltage storage means is thereby used in the same manner to control the switch-on transistor Q8.

## Claims

1. A DC/DC converter, in particular a down-converter, comprising a switching transistor (M1), which is coupled between a DC voltage supply (V3) and a load (3), and a controlling circuit
with a controller (4) delivering driving pulses for the switching transistor (M1),
a transformer (TX1) between the controller (4) and the switching transistor (M1),
a primary circuit with a capacitor (C1) and
a clamping circuit with a capacitor (C2) and a diode (D5, D17),
**characterized in that** the controlling circuit further comprises a timing circuit for switching the switching transistor (M1) off after a certain on- or off-time of the controller (4).

2. The DC/DC converter according to claim 1, wherein the maximum on-time of the switching transistor (M1) has a value between one and two on/off cycles of the controller (4) .

3. The DC/DC converter according to claim 1 or 2, wherein the timing circuit comprises timing elements with a time constant defining the maximum on-time of the switching transistor (M1) .

4. The DC/DC converter according to claim 3, wherein the timing circuit comprises a resistor (R17) and a capacitor (C6) as timing elements.

5. The DC/DC converter according to claim 3 or 4, wherein the timing circuit further comprises voltage storage means, which charges the timing elements.

6. The DC/DC converter according to claim 5 and in connection with claim 4, wherein the timing circuit comprises a capacitor (C4) and a diode (D17), decoupling the capacitor (C4) from the clamping circuit, as voltage storage means.

7. The DC/DC converter according to one of the claims 1 to 5, the controlling circuit further comprising a switch-off circuit with a switch-off transistor (Q4), switching the switching transistor (M1) off after each pulse, wherein the timing circuit controls the switch-off transistor (Q4) .

8. The DC/DC converter according to one of the claims 3 to 7, wherein the timing circuit further comprises a transistor (Q5), which is controlled by the timing elements.

9. The DC/DC converter according to claim 8 and in connection with claim 7, wherein the transistor (Q5) of the timing circuit controls the switch-off transistor (Q4).

10. The DC/DC converter according to claim 7 or a claim relating to claim 7 in connection with claim 5 or a claim relating to claim 5, wherein the voltage storage means are used to control a switch-on transistor (Q8) switching the switching transistor (M1) on, alternating with the switch-off transistor (Q4).
